# EUROPÄISCHE PATENTSCHRIFT

(11) **EP 1 118 127 B1**
(45) Veröffentlichungstag und Bekanntmachung des Hinweises auf die Patenterteilung: **09.11.2005**
(21) Anmeldenummer: 99969849.1
(22) Anmeldetag: 29.09.1999
(51) Int. Cl.: H01L 35/34

(54) **VERFAHREN ZUM HERSTELLEN EINES THERMOELEKTRISCHEN WANDLERS**
PROCESS FOR PRODUCING A THERMOELECTRIC CONVERTER
PROCEDE POUR PRODUIRE UN CONVERTISSEUR THERMOELECTRIQUE

(30) Priorität: 30.09.1998 DE 19845104
(43) Veröffentlichungstag der Anmeldung: 25.07.2001
(73) Patentinhaber: SIEMENS AKTIENGESELLSCHAFT, 80333 München (DE)
(72) Erfinder: SCHLERETH, Karl-Heinz, D-93133 Burglengenfeld (DE); SCHUBERT, Axel, D-81543 München (DE); ACKLIN, Bruno, 93047 Regensburg (DE); BÖTTNER, Harald, D-79108 Freiburg (DE)
(74) Vertreter: Banzer, Hans-Jörg
(86) Internationale Anmeldenummer: PCT/DE1999/003136
(87) Internationale Veröffentlichungsnummer: WO 2000/019548

(56) Entgegenhaltungen:
- EP-A- 0 482 215
- EP-A- 0 506 093
- GB-A- 2 119 170
- PATENT ABSTRACTS OF JAPAN vol. 1997, no. 06, 30. Juni 1997 (1997-06-30) & JP 09 051125 A (SHARP CORP), 18. Februar 1997 (1997-02-18)

## Beschreibung

Die Erfindung bezieht sich auf ein Verfahren zum Herstellen eines thermoelektrischen Wandlers.

In der DE 39 35 610 A1 ist ein Peltier-Kühler beschrieben, der eine Zusammenschaltung von n- und p-dotierten Halbleitersegmenten aufweist, die mit Hilfe von Metallbrücken untereinander verbunden sind. Die Metallbrücken sind hierbei auf Al₂O₃-Substraten aufgebracht und die Halbleitersegmente sind bei einem dieser Substrate auf die dort vorhandenen Metallbrücken aufgedampft. Derartige Peltier-Kühler weisen eine Baugröße im Zentimeter-Bereich auf und sind nicht ohne Weiteres miniatursierbar, so daß die Leistungsdichte sehr gering ist. Weiterhin besitzen die Al₂O₃-Substrate eine sehr geringe thermische Leitfähigkeit, wodurch die Effektivität derartiger Peltierkühler beeinträchtigt ist.

Aus der EP 0 506 093 A1 ist ein Verfahren zur Herstellung eines thermoelektrischen Wandlers bekannt, bei dem auf einer Hauptfläche eines ersten keramischen Substrats erste elektrische Leiterbahnen ausgebildet werden und darauf ein n-dotiertes thermoelektrisches Material und ein p-dotiertes thermoelektrisches Material jeweils in Stabform abwechselnd aufgebracht und durch Schneiden zu n- und p-Körpern strukturiert wird. An der Unterseite eines zweiten keramischen Substrats sind zweite elektrische Leiterbahnen derart ausgebildet, dass bei sandwichartiger Anordnung der n- und p-Körper zwischen den beiden Substraten mehrere in Reihe geschaltete Thermoelementzellen ausgebildet werden.

Ähnliche Verfahren werden auch in der EP 0 482 215 A1, GB 2 119 170 A und JP 09-051125 A beschrieben.

Die Aufgabe der vorliegenden Erfindung besteht darin, ein Verfahren zum Herstellen eines thermoelektrischen Wandlers der eingangs genannten Art zu entwickeln, das eine höhere Integrationsdichte der Thermoelementzellen erlaubt und dadurch die Herstellung von thermoelektrischen Bauelementen mit höherer Leistungsdichte ermöglicht und bei dem kostengünstige Prozesse eingesetzt werden.

Diese Aufgabe wird durch ein Verfahren mit den Merkmalen des Anspruches 1 gelöst. Vorteilhafte Weiterbildungen des Verfahrens sind Gegenstand der Unteransprüche 2 bis 5.

Mittels des Verfahrens gemäß der Erfindung wird ein thermoelektrischer Wandler hergestellt, der eine Mehrzahl von in Reihe geschalteten Thermoelementzellen aufweist, die mittels einer Mehrzahl von ersten elektrischen Leiterbahnen seriell miteinander verbunden sind, und von denen jede einen ersten Körper aus thermoelektrischem Material eines ersten Leitungstyps und einen zweiten Körper aus thermoelektrischem Material eines zweiten Leitungstyps aufweist, die mittels einer zweiten elektrischen Leiterbahn miteinander verbunden sind und die sandwichartig zwischen einem ersten und einem zweiten elektrisch isolierenden oder eine elektrisch isolierende Schicht aufweisenden Substratwafer angeordnet sind.

Bei dem Verfahren werden auf einer Hauptfläche des ersten Substratwafers die ersten elektrischen Leiterbahnen ausgebildet. Auf einer Hauptfläche des zweiten Substratwafers werden die zweiten elektrischen Leiterbahnen erzeugt. Auf beiden Substratwafern wird auf derselben Seite, auf der die Leiterbahnen erzeugt werden, mindestens eine Schicht aus thermoelektrischem Material aufgebracht. Diese wird mittels Photomaskentechnik und Ätzen strukturiert, derart, daß die ersten und zweiten Körper der Thermoelementzellen entstehen.

Nach dem Prozessieren der beiden Substratwafer werden diese z. B. mittels Thermokompression, Löten, Kleben oder anodischem Bonden zu einem Sandwichverbund zusammengefügt, bei dem die ersten und die zweiten Körper zwischen den beiden Substratwafern angeordnet und mittels der ersten und zweiten elektrischen Leiterbahnen zu seriell verschalteten Thermoelementzellen verbunden sind.

Jeweils ein erster und ein zweiter Körper sind auf einer ersten Seite mittels einer ersten Leiterbahn zu einer Thermoelementzelle verbunden, die auf einer der ersten Seite gegenüberliegenden zweiten Seite der ersten und zweiten Körper mittels der zweiten Leiterbahnen seriell miteinander verschaltet sind.

Bei einer bevorzugten Ausführungsform zum Erzeugen der ersten und zweiten Leiterbahnen und der ersten und zweiten Körper wird eine erste elektrisch leitfähige Schicht auf die Hauptfläche des ersten Substratwafers aufgebracht. Dem folgt ein Aufbringen einer ersten Schicht aus thermoelektrischen Material, das vom ersten Leitungstyp ist, auf die erste elektrisch leitfähige Schicht.

Diese erste Schicht aus thermoelektrischem Material wird nachfolgend mittels Photomaskentechnik und Ätzen strukturiert, derart, daß auf der ersten elektrisch leitfähigen Schicht eine Mehrzahl von voneinander getrennten ersten Körpern entstehen.

Nach diesem Prozeßschritt wird die erste elektrisch leitfähige Schicht beispielsweise wiederum mittels Photomaskentechnik und Ätzen zu ersten Leiterbahnen strukturiert.

Auch hier kann die erste elektrisch leitfähige Schicht aber auch bereits vor dem Aufbringen der ersten Schicht aus thermoelektrischem Material zu ersten Leiterbahnen strukturiert werden.

Vor, während oder nach diesen Prozeßschritten wird auf die Hauptfläche des zweiten Substratwafers eine zweite elektrisch leitfähige Schicht aufgebracht, auf der eine zweite Schicht aus thermoelektrischen Material, das vom zweiten Leitungstyp ist, abgeschieden wird.

Diese zweite Schicht aus thermoelektrischem Material wird dann mittels Photomaskentechnik und Ätzen strukturiert, derart, daß auf der zweiten elektrisch leitfähige Schicht eine Mehrzahl von voneinander getrennten zweiten Körpern entstehen.

Nachfolgend wird die zweite elektrisch leitfähige Schicht beispielsweise wiederum mittels Photomaskentechnik und Ätzen zu zweiten Leiterbahnen strukturiert.

Die zweite elektrisch leitfähige Schicht kann auch bereits vor dem Aufbringen der zweiten Schicht aus thermoelektrischem Material zu zweiten Leiterbahnen strukturiert werden.

Das zusammenfügen der beiden Wafer zu einem Sandwichverbund mit seriell verschalteten Thermoelementzellen erfolgt wie weiter oben bereits angegeben.

Der besondere Vorteil des oben genannten Verfahrens besteht darin, daß zur Herstellung der ersten und zweiten Leiterbahnen und der ersten und zweiten Körper Prozesse der Halbleitertechnik eingesetzt werden können. Dadurch lassen sich sowohl die Integrationsdichte der Thermoelementzellen als auch die Herstellkosten für thermoelektrische Wandler erheblich senken. Letzteres ist dadurch bedingt, daß herkömmliche und etablierte Prozesse der Halbleitertechnik, die für die Massenfertigung von Halbleiterchips verwendet werden, eingesetzt werden.

Die nach dem erfindungsgemäßen Verfahren hergestellten thermoelektrischen Wandler können vorteilhafterweise auf einfache Weise zusammen mit Elementen der Mikroelektronik und/oder Mikrosystemtechnik auf ein und demselben Chip integriert werden.

Mit dem erfindungsgemäßen Verfahren können die ersten und die zweiten Körper auf einfache Weise aus Vielschichtsystemen hergestellt werden, die aus einer Vielzahl von dünnen Schichten unterschiedlicher Materialzusammensetzung bestehen. Dadurch kann vorteilhafterweise durch die Verwendung von exakt aufeinander abgestimmten Schichtfolgen die Leistungsfähigkeit von thermoelektrischen Wandlern erhöht werden.

Im Folgenden werden in Verbindung mit der Zeichnung Ausführungsbeispiele der Erfindung erläutert. Es zeigen:
Figuren 1a bis 1g eine schematische Darstellung eines Verfahrensablaufes zur Herstellung eines thermoelektrischen Wandlers,
Figuren 2a bis 2i eine schematische Darstellung eines weitere Verfahrensablaufes zur Herstellung eines thermoelektrischen Wandlers,
Figuren 3a bis 3h eine schematische Darstellung eines Verfahrensablaufes gemäß einem Ausführungsbeispiel der Erfindung, und
Figuren 4a bis 4c räumliche Darstellungen eines thermoelektrischen Wandlers, der nach dem Ausführungsbeispiel hergestellt ist.

In den Figuren sind gleiche oder gleichwirkende Bestandteile jeweiles mit denselben Bezugszeichen versehen.

Bei dem in den Figuren la bis 1g dargestellten Beispiel, welches nicht Bestandteil der Erfindung, wird zunächst auf einer Hauptfläche 8 eines ersten Substratwafers 1 eine erste elektrisch leitfähige Schicht 10 hergestellt. Diese besteht z. B. aus einer Metallschicht, aus einer Metallschichtfolge oder aus einer hochdotierten und damit hochleitfähigen Halbleiterschicht (z. B. diffundiertes Silizium).

Der erste Substratwafer 1 hat insgesamt eine geringe elektrische Leitfähigkeit und besteht beispielsweise aus semi-isolierendem Silizium oder weist auf der Seite der Hauptfläche 8 eine elektrisch isolierende Schicht 14 (z. B. eine Si-Oxid- oder Si-Nitridschicht) auf.

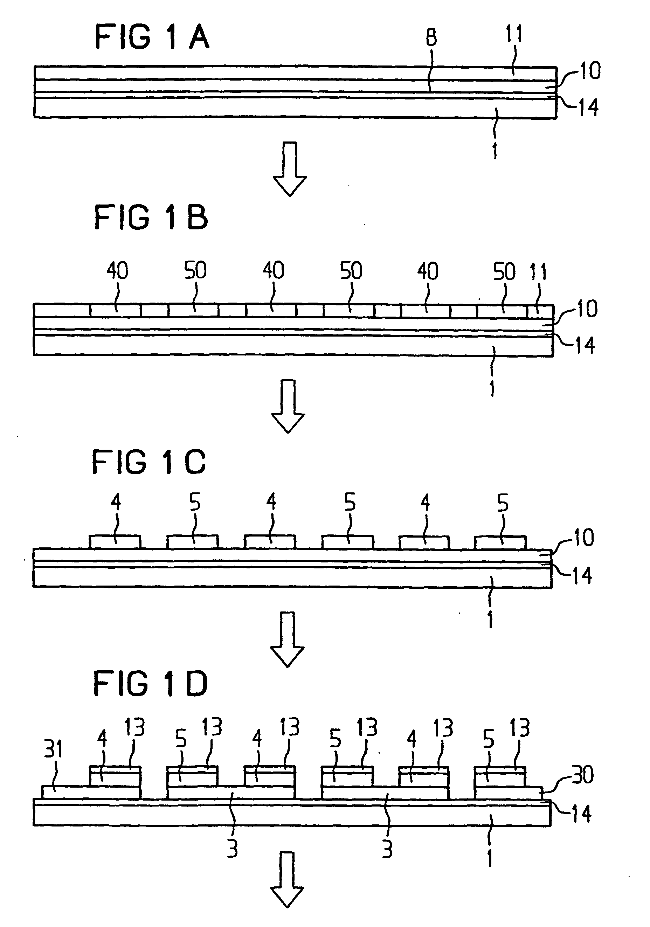

Auf der ersten elektrisch leitfähigen Schicht 10 wird eine Schicht 11 aus thermoelektrischem Material abgeschieden (z. B. Bi₂Te₃, Bi₂Se₃, PbTe, Si, Ge etc.) (Figur 1a), in der nachfolgend mittels Photomaskentechnik und Diffusion eine Mehrzahl von dotierten Gebieten 40 eines ersten Leitungstyps (z. B. p-leitend) und eine Mehrzahl von dotierten Gebieten 50 eines zweiten Leitungstyps (n-leitend) ausgebildet werden (Figur 1b).

Die Schicht 11 mit den dotierten Gebieten 40,50 wird dann mittels eines oder mehrerer herkömmlicher aus der Halbleitertechnik bekannter Photomasken- und Ätzprozesse zu ersten 4 und zweiten Körpern 5 strukturiert (Figur 1c).

Nachfolgend wird die erste elektrisch leitfähige Schicht 10 ebenfalls mittels Photomaskentechnik und Ätzen derart strukturiert, daß auf dem ersten Substratwafer 1 eine Mehrzahl von voneinander getrennten Thermoelementzellen entstehen, die jeweils einen ersten Körper 4 und einen zweiten Körper 5 und eine diese verbindende erste elektrische Leiterbahn 3 aufweisen (Figur 1d).

Die Strukturierung der ersten elektrisch leitfähigen Schicht 10 kann alternativ zu der oben beschriebenen Vorgehensweise auch vor dem Aufbringen der Schicht 11 aus thermoelektrischem Material erfolgen.

Weiterhin wird auf die der ersten Leiterbahn 3 gegenüberliegenden Seiten der ersten und zweiten Körper 4, 5 jeweils eine Metallisierungsschicht 13 aufgebracht, die z. B. aus einem Lot (z. B. AuSn) oder aus Gold besteht (Figur 1d).

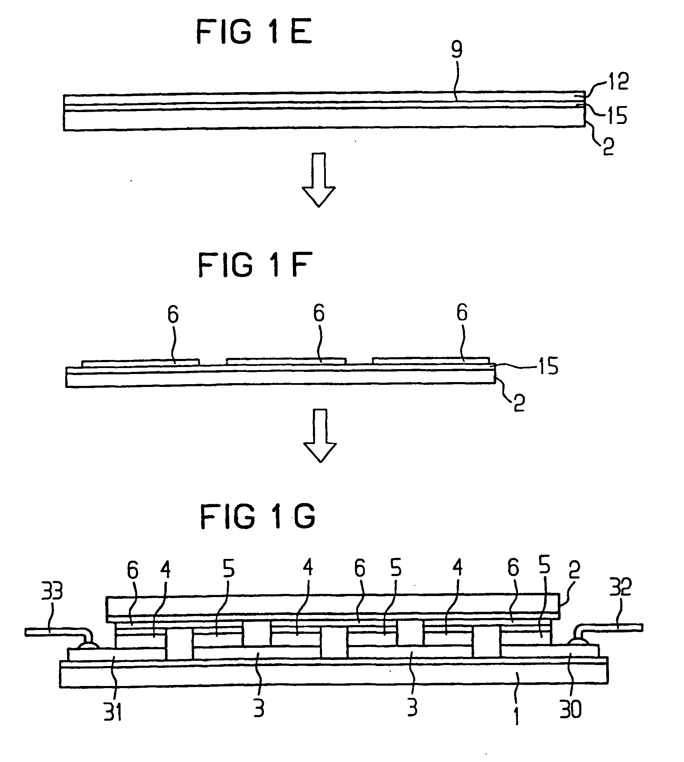

Vor, während oder nach diesem ersten Waferprozeß wird auf einer Hauptfläche 9 eines zweiten Substratwafers 2 eine zweite elektrisch leitfähige Schicht 12 ausgebildet (Figur 1e) und zu zweiten elektrischen Leiterbahnen 6 strukturiert (Figur 1f).

Analog zum Substratwafer 1 hat der zweite Substratwafer 2 insgesamt eine geringe elektrische Leitfähigkeit und besteht beispielsweise aus semi-isolierendem Silizium oder weist der Substratwafer 2 auf der Seite der Hauptfläche 9 eine elektrisch isolierende Schicht 15 (z. B. eine Si-Oxid- oder Si-Nitridschicht) auf.

Der zweite Substratwafer 2 wird nach der Strukturierung der zweiten Leiterbahnen 6 mit diesen auf die Metallisierungsschichten 13 der ersten und zweiten Körper 4,5 gelegt und derart ausgerichtet, daß die zweiten Leiterbahnen 6 auf den Metallisierungsschichten 13 der ersten und zweiten Körper 4,5 aufliegen und die vorher gebildeten Paare aus jeweils einem ersten und einem zweiten Körper 4,5 seriell miteinander verschalten (Figur 1g).

Nachfolgend werden die zweiten elektrischen Leiterbahnen 6 und die Metallisierungsschichten 13 beispielsweise mittels Löten, Kleben oder Thermokompression miteinander verbunden.

Dieser Sandwichverbund aus den beiden Substratwafern 1,2 und den dazwischenliegenden Thermoelementzellen wird dann zu mehreren thermoelektrischen Wandlern vereinzelt, z. B. durch Sägen. Es können aus einem Sandwichverbund eine Mehrzahl verschiedener oder gleichartiger thermoelektrischer Wandler erzeugt werden. Die jeweils erste und letzte Thermoelementzelle einer Serienschaltung von Thermoelementzellen eines thermoelektrischen Wandlers weist je eine elektrische Anschlußfläche 30,31 auf, über die der thermoelektrische Wandler beispielsweise mittels Bonddrähten 32,33 elektrisch angeschlossen werden kann.

Die thermoelektrischen Wandler können aber ohne weiteres auch als SMD(Surface Mount Device)-Bauelemente ausgeführt werden, indem die elektrischen Anschlußflächen 30,31 elektrisch leitend auf die der Hauptfläche 8 gegenüberliegende Seite des ersten Substratwafers 1 geführt werden.

Vorteilhaft beim Vereinzeln des Sandwichverbunds ist ein zweiteiliger Sägeprozeß, bei dem einer der beiden Substratwafer 1,2 kleiner hergestellt wird als der andere. Dies erleichtert das elektrische Anschließen des thermoelektrischen Wandlers (man vgl. Figur 1g).

Die Leiterbahnen 3,6 können alternativ zum oben beschriebenen Verfahren (ganzflächiges Beschichten der Substratwafer und nachträgliches Strukturieren) mittels Maskieren und Metallisieren oder Diffundieren von Dotierstoff in den jeweiligen Substratwafer 1,2 unmittelbar strukturiert hergestellt werden.

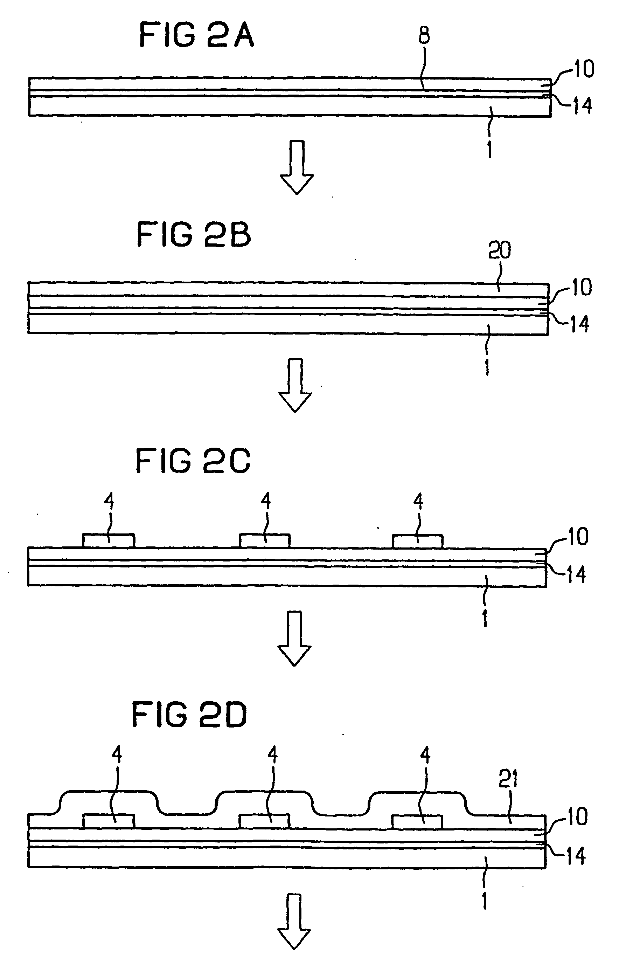

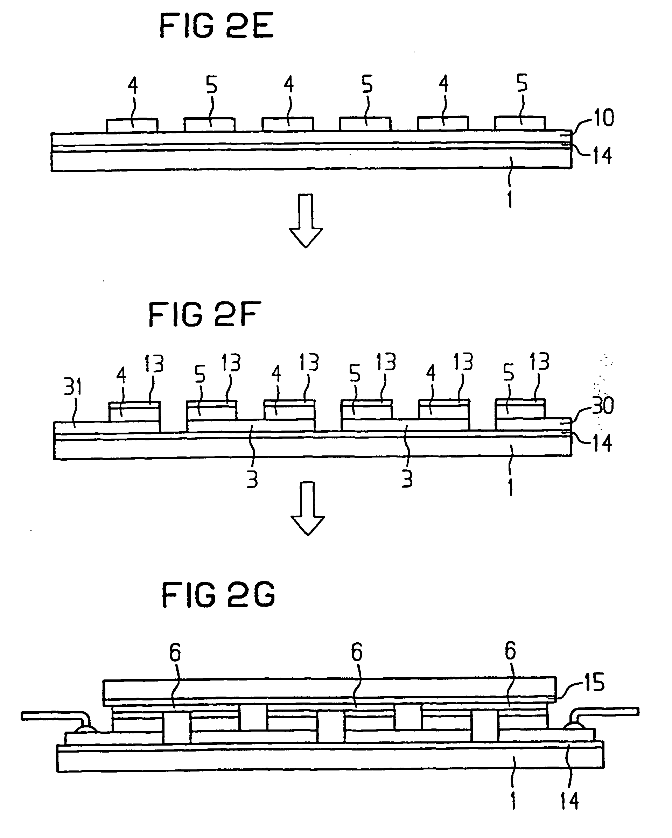

Das in den Figuren 2a bis 2g dargetellte Beispiel, welches ebenfalls nicht Bestandteil der Erfindung ist, unterscheidet sich von dem vorgenannten im Wesentlichen dadurch, daß zum Herstellen der ersten 4 und zweiten Körper 5 folgende Verfahrensschritte durchgeführt werden:
- nach dem Ausbilden der ersten elektrisch leitfähigen Schicht 10 wird auf diese eine erste Schicht 20 aus thermoelektrischem Material, das den ersten Leitungstyp aufweist, abgeschieden (Figuren 2a und 2b);
- die erste Schicht 20 wird mittels Photomaskentechnik und Ätzen strukturiert, derart, daß auf der ersten elektrisch leitfähigen Schicht 10 eine Mehrzahl von voneinander getrennten Körpern 4 entsteht (Figur 2c);
- auf die nach der Strukturierung der ersten Schicht 20 zwischen :den ersten Körpern 4 freiliegende Oberfläche der ersten elektrisch leitfähigen Schicht 10 und auf die ersten Körper 4 wird eine zweite Schicht aus thermoelektrischem Material 21 aufgebracht, das den zweiten Leitungstyp aufweist(Figur 2d); und
- die zweite Schicht aus thermoelektrischem Material 21 wird mittels Photomaskentechnik und Ätzen strukturiert, derart, daß auf der ersten elektrischen Schicht 10 zwischen den ersten Körpern 4 eine Mehrzahl von zweiten Körpern 5 entstehen (Figur 2e).

Die erste elektrisch leitfähige Schicht 10 kann vor oder nach dem Aufbringen der ersten 20 und zweiten Schicht 21 aus thermoelektrischem Material zu ersten elektrischen Leiterbahnen 3 strukturiert werden.

Die Herstellung des zweiten Substratwafers 2 mit den zweiten elektrischen Leiterbahnen 6 und das Verbinden der beiden Wafer erfolgt analog zum ersten Ausführungsbeispiel (Figuren 2f und 2g).

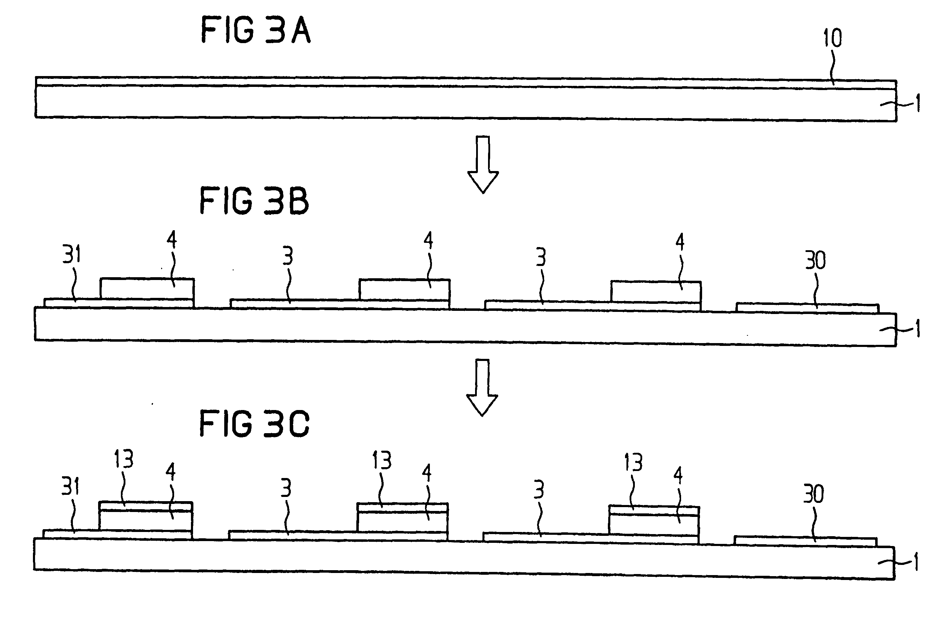

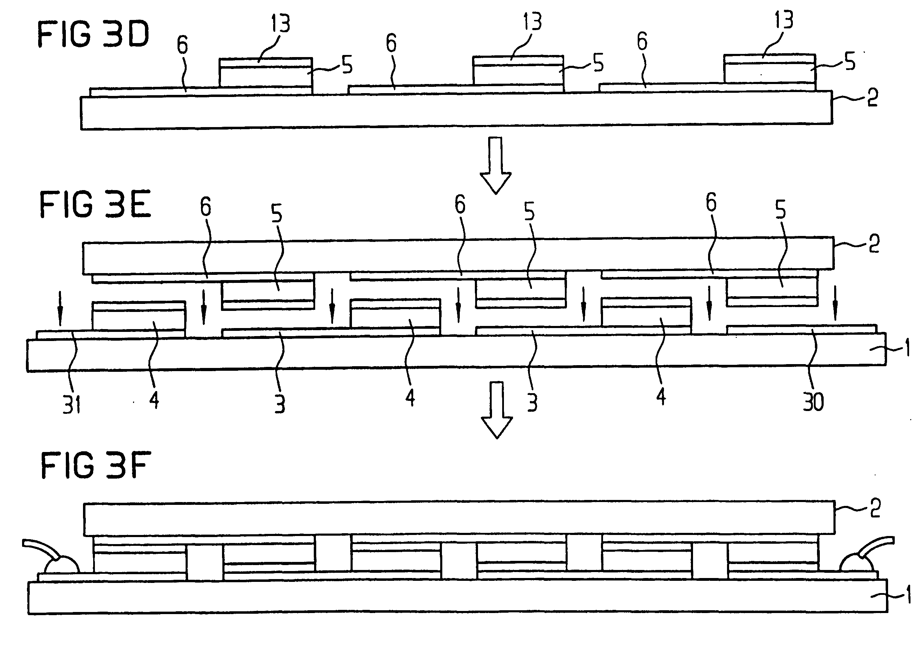

Bei dem in den Figuren 3a bis 3f dargestellten Ausführungsbeispiel unterscheidet sich das Verfahren zum Herstellen der ersten und zweiten Körper 4,5 von dem der Figuren 2a bis 2e im Wesentlichen dadurch, daß die zweite Schicht 21 aus thermoelektrischem Material, das den zweiten Leitungstyp aufweist, nicht auf dem ersten Substratwafer 1 abgeschieden wird. Hier wird nach dem Ausbilden der zweiten elektrisch leitfähigen Schicht 12 auf der Hauptfläche 9 des zweiten Substratwafers 2 auf dieser die zweite Schicht aus thermoelektrischem Material 21 abgeschieden und nachfolgend mittels Photomaskentechnik und Ätzen strukturiert, derart, daß auf der zweiten elektrisch leitenden Schicht 12 die zweiten Körper 5 entstehen.

Bei den Verfahren der Figuren 1a bis 1g und der Figuren 3a bis 3e kann oder können alternativ zum Verfahren mittels Abscheiden, die Schicht 11 aus thermoelektrischem Material bzw. die erste 20 und zweite Schicht 21 aus thermoelektrischem Material als Wafer hergestellt werden, die mit dem ersten Substratwafer 1 bzw. mit dem ersten 1 bzw. dem zweiten Substratwafer 2 mittels Waferbonden verbunden werden. Als Bond- und Metallisierungsmaterial (für die elektrischen Leiterbahnen) kann Wolframsilizid verwendet werden.

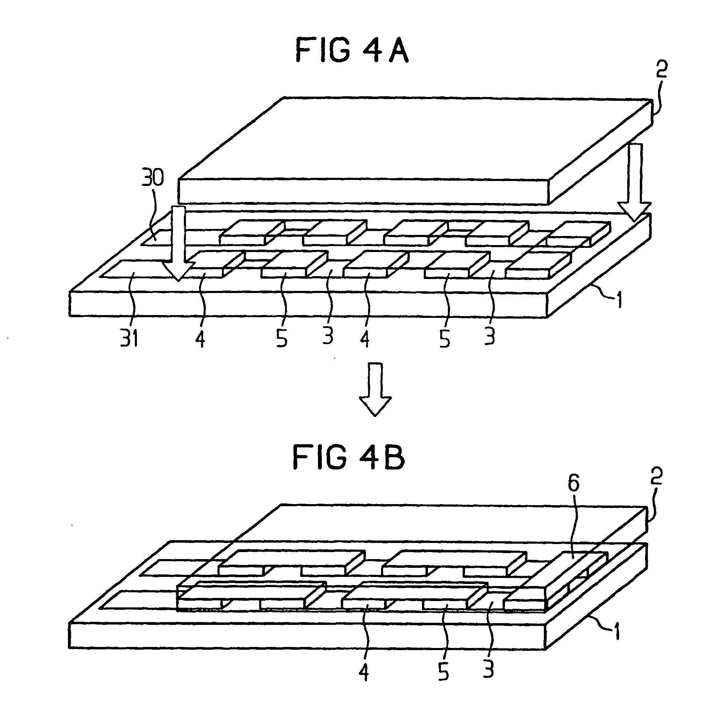

In den Figuren 4a und 4b sind räumliche Darstellungen eines thermoelektrischen Wandlers gezeigt, der nach einem der oben beschriebenen Verfahren hergestellt ist. Figur 4a ist eine Explosionsdarstellung und in Figur 4b ist der zweite Substratwafer 2 transparent dargestellt.

Die Dicke der Substratwafer 1,2 beträgt bei den oben beschriebenen Ausführungsbeispielen vorteilhafterweise 100 - 300 µm. Die Dicke der Schichten 11,20,21 aus thermoelektrischem Material beträgt vorzugsweise ca. 50 µm. Die Dicke der elektrisch leitenden Schichten 10,12 beträgt etwa 1 µm.

## Patentansprüche

1. Verfahren zum Herstellen eines thermoelektrischen Wandlers mit einer Mehrzahl von in Reihe geschalteten Thermoelementzellen, die mittels einer Mehrzahl von ersten elektrischen Leiterbahnen (3) seriell miteinander verbunden sind und von denen jede einen ersten Körper (4) aus thermoelektrischem Material eines ersten Leitungstyps und einen zweiten Körper (5) aus thermoelektrischem Material eines zweiten Leitungstyps aufweist, die mittels einer zweiten elektrischen Leiterbahn (6) miteinander verbunden sind und die sandwichartig zwischen einem ersten und einem zweiten elektrisch isolierenden oder eine elektrisch isolierende Schicht (14, 15) aufweisenden Substratwafer (1, 2) angeordnet sind,
wobei die folgenden Verfahrensschritte zum Einsatz kommen:
• Ausbilden einer ersten elektrisch leitfähigen Schicht (10) auf einer Hauptfläche (8) des ersten Substratwafers (1),
• Aufbringen einer ersten Schicht aus thermoelektrischem Material (20), das den ersten Leitungstyp aufweist, auf die erste elektrisch leitfähige Schicht (10),
• Strukturieren der ersten Schicht aus thermoelektrischem Material (20) zu den ersten Körpern (4) mittles Photomashentechnik und Ätzen,
• Strukturieren der ersten elektrisch leitfähigen Schicht (10) zu den ersten Leiterbahnen (3),
• Ausbilden einer zweiten elektrisch leitfähigen Schicht (12) auf eine Hauptfläche (9) des zweiten Substratwafers (2),
• Aufbringen einer zweiten Schicht aus thermoelektrischem Material (21), das den zweiten Leitungstyp aufweist, auf die zweite elektrisch leitfähige Schicht (12),
• Strukturieren der zweiten Schicht aus thermoelektrischem Material (21) zu den zweiten Körpern (5) mittles Photomashentechnik und Ätzen,
• Strukturieren der zweiten elektrisch leitfähigen Schicht (12) zu den zweiten Leiterbahnen (6), und
• Verbinden des ersten und zweiten Substratwafers (1, 2) miteinander derart, dass die ersten und zweiten elektrischen Leiterbahnen (3, 6) und die ersten und die zweiten Körper (4, 5) zwischen den beiden Substratwafern (1, 2) angeordnet sind und die Mehrzahl von in Reihe geschalteten Thermoelementzellen ausbilden.

2. Verfahren nach Anspruch 1, bei dem vor dem Aufbringen der ersten Schicht aus thermoelektrischem Material (20) die erste elektrisch leitfähige Schicht (10) zu ersten Leiterbahnen (3) strukturiert wird und/oder vor dem Aufbringen der zweiten Schicht aus thermoelektrischem Material (21) die zweite elektrisch leitfähige Schicht (12) zu zweiten Leiterbahnen (6) strukturiert wird.

3. Verfahren nach Anspruch 1 oder 2, erste (20) und die zweite Schicht (21) aus thermoelektrischem Material als Wafer hergestellt werden, die mit dem ersten (1) bzw. dem zweiten Substratwafer (2) mittels Waferbonden, insbesondere mittels Thermokompression, Löten, Kleben oder anodischem Bonden, verbunden werden.

4. Verfahren nach einem der Ansprüche 1 bis 3, bei dem als Substratwafer (1,2) Si-Wafer verwendet werden.

5. Verfahren nach einem der Ansprüche 1 bis 4, bei dem die ersten und die zweiten Körper aus Vielschichtsystemen hergestellt werden, die aus einer Vielzahl von Schichten unterschiedlicher Materialzusammensetzung bestehen.

## Claims

1. A method for fabricating a thermoelectric converter having a plurality of series-connected thermoelement cells, which are connected in series with one another by means of a plurality of first electrical conductor tracks (3) and each of which has a first body (4) made of thermoelectric material of a first conduction type and a second body (5) made of thermoelectric material of a second conduction type, which are connected to one another by means of a second electrical conductor track (6) and which are arranged in a sandwich-like manner between a first and a second substrate wafer (1, 2) which is electrically insulating or has an electrically insulating layer (14, 15), the following method steps being used:
• formation of a first electrically conductive layer (10) on a main area (8) of the first substrate wafer (1),
• application of a first layer made of thermoelectric material (20), which has the first conduction type, to the first electrically conductive layer (10),
• patterning of the first layer made of thermoelectric material (20) to form the first bodies (4) by means of photomask technology and etching,
• patterning of the first electrically conductive layer (10) to form the first conductor tracks (3),
• formation of a second electrically conductive layer (12) on a main area (9) of the second substrate wafer (2),
• application of a second layer made of thermoelectric material (21) which has the second conduction type to the second electrically conductive layer (12),
• patterning of the second layer made of thermoelectric material (21) to form the second bodies (5) by means of photomask technology and etching,
• patterning of the second electrically conductive layer (12) to form the second conductor tracks (6), and
• connection of the first and the second substrate wafer (1, 2) to one another in such a way that the first and second electrical conductor tracks (3, 6) and the first and the second bodies (4, 5) are arranged between the two substrate wafers (1, 2) and form the plurality of series-connected thermoelement cells.

2. The method as claimed in claim 1, in which, prior to the application of the first layer made of thermoelectric material (20) the first electrically conductive layer (10) is patterned to form first conductor tracks (3) and/or prior to the application of the second layer made of thermoelectric material (21) the second electrically conductive layer (12) is patterned to form second conductor tracks (6).

3. The method as claimed in claim 1 or 2, in which the first layer (20) and the second layer (21) made of thermoelectric material are fabricated as wafers which are connected to the first substrate wafer (1) or respectively the second substrate wafer (2) by means of wafer bonding, in particular by means of thermocompression, soldering, adhesive bonding or anodic bonding.

4. The method as claimed in one of claims 1 to 3, in which Si wafers are used as the substrate wafers (1, 2).

5. The method as claimed in one of claims 1 to 4, in which the first and the second bodies are fabricated from multilayer systems comprising a multiplicity of layers having a different material composition.

## Revendications

1. Procédé de fabrication d'un convertisseur thermoélectrique comprenant une multitude de cellules à thermocouples montées en série qui sont reliées les unes aux autres en série au moyen d'une multitude de premières pistes conductrices électriques (3) et dont chaque première piste présente un premier corps (4) en matériau thermoélectrique d'un premier type de conduction et un deuxième corps (5) en matériau thermoélectrique d'un deuxième type de conduction, qui sont reliés l'un à l'autre au moyen d'une deuxième piste conductrice électrique (6) et disposés en forme de sandwich entre une première et une deuxième plaquettes de support (1, 2) isolantes électriquement ou présentant une couche (14, 15) isolante électriquement, comprenant les étapes de procédé suivantes :
. formation d'une première couche (10) conductrice électriquement (10) sur une surface principale (8) de la première plaquette de support (1),
. application sur la première couche (10) conductrice électriquement d'une première couche en matériau thermoélectrique (20) qui présente le premier type de conduction,
. structuration de la première couche en matériau thermoélectrique (20) pour obtenir les premiers corps (4) au moyen de la technique de photomasques et par gravure,
. structuration de la première couche (10) conductrice électriquement pour obtenir les premières pistes conductrices (3),
. formation d'une deuxième couche (12) conductrice électriquement sur une surface principale (9) de la deuxième plaquette de support (2),
. application sur la deuxième couche (12) conductrice électriquement d'une deuxième couche en matériau thermoélectrique (21) qui présente le deuxième type de conduction,
. structuration de la deuxième couche en matériau thermoélectrique (21) pour obtenir les deuxièmes corps (5) au moyen de la technique de photomasques et par gravure,
. structuration de la deuxième couche (12) conductrice électriquement pour obtenir les deuxièmes pistes conductrices (6), et
. assemblage l'une avec l'autre des première et deuxième plaquettes de support (1, 2) de telle sorte que les premières et deuxièmes pistes conductrices (3, 6) et les premiers et deuxièmes corps (4, 5) se trouvent entre les deux plaquettes de support (1, 2) et forment la multitude de cellules à thermocouples montées en série.

2. Procédé selon la revendication 1, dans lequel avant l'application de la première couche en matériau thermoélectrique (20), la première couche (10) conductrice électriquement est structurée pour former les premières pistes conductrices (3) et/ou avant l'application de la deuxième couche en matériau thermoélectrique, la deuxième couche conductrice électriquement (12) est structurée pour former les deuxièmes pistes conductrices (6).

3. Procédé selon la revendication 1 ou 2, dans lequel la première (20) et la deuxième couches (21) en matériau thermoélectrique sont réalisées en forme de plaquettes reliées à la première (1) ou la deuxième plaquette de support (2) par métallisation, notamment par thermocompression, brasage, collage ou métallisation anodique.

4. Procédé selon l'une quelconque des revendications 1 à 3, dans lequel on utilise comme plaquettes de support (1, 2) des plaquettes en Si.

5. Procédé selon l'une quelconque des revendications 1 à 4, dans lequel les premiers et deuxièmes corps sont réalisés à partir de systèmes multicouches comprenant une multitude de couches d'une composition de matériaux différents
